# EUROPEAN PATENT SPECIFICATION

(11) **EP 4 436 350 B1**
(45) Date of publication and mention of the grant of the patent: **24.12.2025**
(21) Application number: 23162996.5
(22) Date of filing: 20.03.2023
(51) Int. Cl.: H10N 99/00

(54) **QUANTIZATION BREAKDOWN PROTECTION FOR SEMICONDUCTORS AND IN PARTICULAR TOPOLOGICAL INSULATORS**
QUANTISIERUNGS-DURCHBRUCHSCHUTZ FÜR HALBLEITER UND INSBESONDERE TOPOLOGISCHE ISOLATOREN
PROTECTION CONTRE LES PANNES PAR QUANTISATION POUR LES SEMI-CONDUCTEURS ET EN PARTICULIER LES ISOLANTS TOPOLOGIQUES

(43) Date of publication of application: 25.09.2024
(73) Proprietor: Julius-Maximilians-Universität Würzburg, 97070 Würzburg (DE)
(72) Inventor: FIJALKOWSKI, Kajetan, Würzburg (DE); GOULD, Charles, Würzburg (DE)
(74) Representative: Koplin, Moritz

(56) References cited:
- EP-A1- 3 975 275
- FIJALKOWSKI KAJETAN M. ET AL: "Quantum anomalous Hall edge channels survive up to the Curie temperature", NATURE COMMUNICATIONS, vol. 12, no. 1, 22 September 2021 (2021-09-22), XP093076081, DOI: 10.1038/s41467-021-25912-w

## Description

### Field

The present disclosure relates protecting structures made of semiconducting materials such as topological insulators from quantization breakdown. In particular, the present disclosure relates to protecting a structure made of a magnetic topological insulator against quantization breakdown which causes a bulk between a first edge of the structure and a second edge of the structure to conduct electrical charges between the edges.

### Background

At low temperatures, the charge transport within a magnetic topological insulator may be confined to its chiral edge states. See Fijalkowski, Kajetan M., Nan Liu, Pankaj Mandal, Steffen Schreyeck, Karl Brunner, Charles Gould, and Laurens W. Molenkamp. "Quantum Anomalous Hall Edge Channels Survive up to the Curie Temperature". Nature Communications 12, Nr. 1 (22. September 2021). Alternatively, chiral edge states may be created in a two-dimensional semiconductor in a magnetic field. Moreover, the charge transport along a chiral edge may be quantized and used to determine the von Klitzing constant.

### Summary

The present invention is directed at a method of protecting a structure made of a semiconducting material against quantization breakdown which causes a bulk between a first edge of the structure and a second edge of the structure to conduct electrical charges between the edges. Furthermore, the present invention is directed at a measuring apparatus.

A method according to the present invention comprises causing two independent electrical currents along the edges and adapting a first electric potential along a first segment of the first edge, which is delimited by a first electric contact and a second electric contact through which a first voltage is applied to the first segment, to a second electric potential along a second segment of the second edge, which is delimited by a third electric contact and a fourth electric contact through which a second voltage is applied to the second segment.

The semiconducting material is a magnetic topological insulator.

In this regard, the term "magnetic topological insulator", as used throughout the description and the claims, particularly refers to a material which exhibits quantum anomalous Hall conductivity along its edges. Furthermore, the term "quantization breakdown", as used throughout the description and the claims, particularly refers to conditions under which the edges are electrically connected through the then-conducting bulk. Moreover, the term "bulk", as used throughout the description and the claims, particularly refers to a material between the edges.

In addition, the formulation "segment delimited by electric contacts", as used throughout the description and the claims, particularly refers to a segment which extends from one contact to the other. Finally, the formulation "electric potential along a segment of the edge", as used throughout the description and the claims, particularly refers to a specific electric potential if the potential does not change along the segment or a function mapping different parts of the segment to different electric potentials if there are different electric potentials along the segment.

Adapting the first electric potential to the second electric potential allows for ensuring a lower voltage across the bulk. This in turn protects the structure against breakdown for which the voltage is a driver. In other words, the electric field caused by the second electric potential compensates the electric field caused by the first electric potential such that the resulting electric field is (significantly) reduced, and in the ideal case becomes zero across the bulk. Otherwise, the uncompensated electric field caused by the first electric potential may result in electrical charge transport across the bulk.

The structure forms a ring having an outer edge and an inner edge. The outer edge of the ring constitutes the first edge and the inner edge of the ring constitutes the second edge. The structure may be a multi-terminal Corbino device with two disconnected perimeters such as a Corbino ring with chiral inner and outer edges (i.e., dissipationless inner and outer chiral edge channels).

The ring may be divided into a first half and a second half, wherein the first segment constitutes the outer edge of the first half and the second segment constitutes the inner edge of the first half. Accordingly, the first and second segments may lie at opposite sides of the bulk and (fully) overlap in the radial direction.

The first electric contact and the third electric contact may be arranged at a first end of the first half, and the second electric contact and the fourth electric contact may be arranged at a second end of the first half. The second voltage between the third electric contact and the fourth electric contact may be inverse to the first voltage between the first electric contact and the second electric contact. Accordingly, the currents along the outer and inner edges may run in opposite directions.

The electric potential of the first electric contact may be equal to an electric potential of the fourth electric contact, and an electric potential of the second electric contact may be equal to an electric potential of the third electric contact.

Thus, the first contact and the third contact may form a first contact pair, and the second contact and the fourth contact may form a second contact pair, wherein the contacts forming a contact pair are (only) radially displaced relative to one another and the voltages across the contact pairs are inverse to each other.

The above-described steps may be used in a method of determining the von Klitzing constant which comprises the further steps of measuring a third electric potential of the first edge between the first electric contact and the second electric contact, measuring a fourth electric potential of the first edge outside of the first segment, between the second electric contact and the first electric contact, and determining, based on the measured third electric potential and the measured fourth electric potential, the von Klitzing constant. For these purposes, the first and second edge can be assigned to be outer and inner edge or inner and outer edge.

The structure may be exposed to an external magnetic field before or during measuring the third electric potential.

The structure may be arranged in a measuring apparatus which further comprises a Josephson junction or a Josephson junction array. For example, the structure and the Josephson junction (array) may form part of a Kibble balance.

The structure and the Josephson junction or the Josephson junction array may be shielded from external magnetic fields while measuring the third and fourth electric potentials and collecting measurement data for determining the Josephson constant.

A measuring apparatus according to the present invention comprises a structure made of a material hosting chiral edge states. The chiral edge states may result from cooling the material to below its Curie temperature in the case of a magnetic material, or alternatively by applying a magnetic field. The apparatus includes a cooling device and/or a device to apply a magnetic field, as appropriate to generate the chiral edge states. The apparatus includes a controller configured to inject a first electrical current into the first edge and a second electrical current into the second edge, wherein the controller is further configured to cause the first electrical current and the second electrical current to flow in opposite directions.

The first electrical current may flow along a first path across a first segment of the first edge and the second electrical current may flow along a second path across a second segment of the second edge. The controller may be further configured to cause a voltage between the first segment and the second segment across a bulk of the structure to be zero. In other words, the inversely biased segments may compensate each other and thus avoid generating a non-zero electric field across the bulk.

The structure may form a Corbino ring having an outer edge and an inner edge. The outer edge of the Corbino ring may constitute the first edge and the inner edge of the Corbino ring may constitute the second edge.

The Corbino ring may comprise a first half and a second half. The first segment may constitute the outer edge of the first half and the second segment may constitute the inner edge of the first half.

The measuring apparatus may further comprise a first electric contact and a third electric contact arranged at a first end of the first half, and a second electric contact and a fourth electric contact arranged at a second end of the first half, wherein a first voltage between the first electric contact and the second electric contact drives the first electrical current and a second voltage between the third electric contact and the fourth electric contact drives the second electrical current.

An electric potential of the first electric contact may be equal to an electric potential of the fourth electric contact, and an electric potential of the second electric contact may be equal to an electric potential of the third electric contact.

Notably, the (optional) features of the method may be (optional) features of the apparatus and vice versa.

### Brief Description of Drawings

The foregoing aspects and many of the attendant advantages will become more readily appreciated as the same become better understood by reference to the following description of embodiments, when taken in conjunction with the accompanying drawings, wherein like reference numerals refer to like parts throughout the various views, unless otherwise specified.
Fig. 1 schematically illustrates a structure made of a magnetically doped topological insulator having a first chiral edge and a second chiral edge which are separated by an insulating bulk, according to a first example;
Fig. 2 schematically illustrates an apparatus comprising the structure shown in Fig. 1 and a controller for inversely biasing the chiral edge channels to protect the structure from electric field-induced quantization breakdown;
Fig. 3 schematically illustrates a modification to the structure shown in Fig. 1 according to a second example;
Fig. 4 schematically illustrates an apparatus comprising the modified structure shown in Fig. 3 and a controller for inversely biasing the chiral edge channels to protect the modified structure from electric field-induced quantization breakdown;
Fig. 5 illustrates the use of the apparatus shown in Fig. 4 to measure the von Klitzing constant;
Fig. 6 illustrates a modification to the apparatus shown in Fig. 5.
Fig. 7 illustrates a modification of the apparatus shown in Fig. 5 or Fig. 6; and
Fig. 8 shows steps of a process for protecting a structure made of a magnetic topological insulator against quantization breakdown which causes a bulk between a first edge of the structure and a second edge of the structure to conduct electrical charges between the edges.

Notably, the drawings are not drawn to scale and unless otherwise indicated, they are merely intended to conceptually illustrate the structures and procedures described herein.

### Description of Embodiments

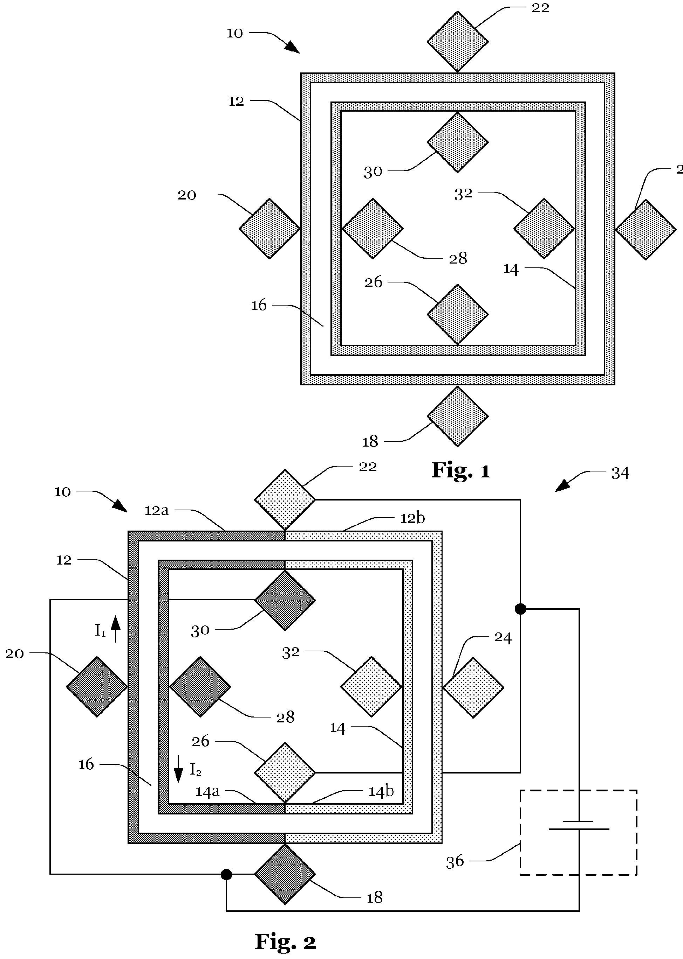

Fig. 1 shows a structure 10 made of a semiconducting material such as a magnetically doped topological insulator (e.g., V_{0.1}(Bi_{0.2}Sb_{0.8})_{1.9}Te₃) which has been cooled by a cooling device (not shown) to below its Curie temperature T_{C}. As a result, the chiral edges 12 and 14 of the structure 10 are electrically disconnected from each other by the insulating bulk 16 which extends along a closed path between the chiral edges 12 and 14. An ohmic contact to the outer chiral edge 12 is provided by the outer electric contacts 18, 20, 22, and 24 and an ohmic contact to the inner chiral edge 14 is provided by the inner electric contacts 26, 28, 30, and 32.

As an alternative to the magnetically doped topological insulator, a two-dimensional semiconductor operating in a magnetic field may also be used to produce the chiral edge states.

As shown in Fig. 2, the structure 10 may be arranged in an apparatus 34 which comprises a controller 36. The controller 36 may be configured to inject an electrical current I₁ through electric contact 18 into the outer chiral edge 12 by applying a voltage to outer electric contacts 18 and 22. Likewise, the controller 36 may be configured to inject an electrical current I₂ through electric contact 30 into the inner chiral edge 14 by applying a voltage to inner electric contacts 26 and 30. The chiral edge segments 12a and 14a may then equilibrate the electric potential along the segments 12a and 14a with the (source) electric contacts 18 and 30, respectively. Notably, the electric contacts 22 and 26 may be grounded so that the chiral edge segments 12b and 14b may equilibrate the electric potential along those segments with ground.

As indicated by the arrows, the first electrical current I₁ and the second electrical I₂ current may flow in opposite directions. Moreover, as schematically illustrated in Fig. 2 by different shadings, the injected electrical currents I₁ and I₂ divide the chiral edges 12 and 14 into two segments 12a and 12b and 14a and 14b, respectively, which differ regarding the electric potential along the segments 12a and 12b and 14a and 14b, respectively. Because the segments 12a and 14a that exhibit the higher electric potential are arranged vis-à-vis each other (as are the segments 12b and 14b which exhibit the lower electric potential), the electric field across the bulk 16 may be significantly reduced, or ideally zero.

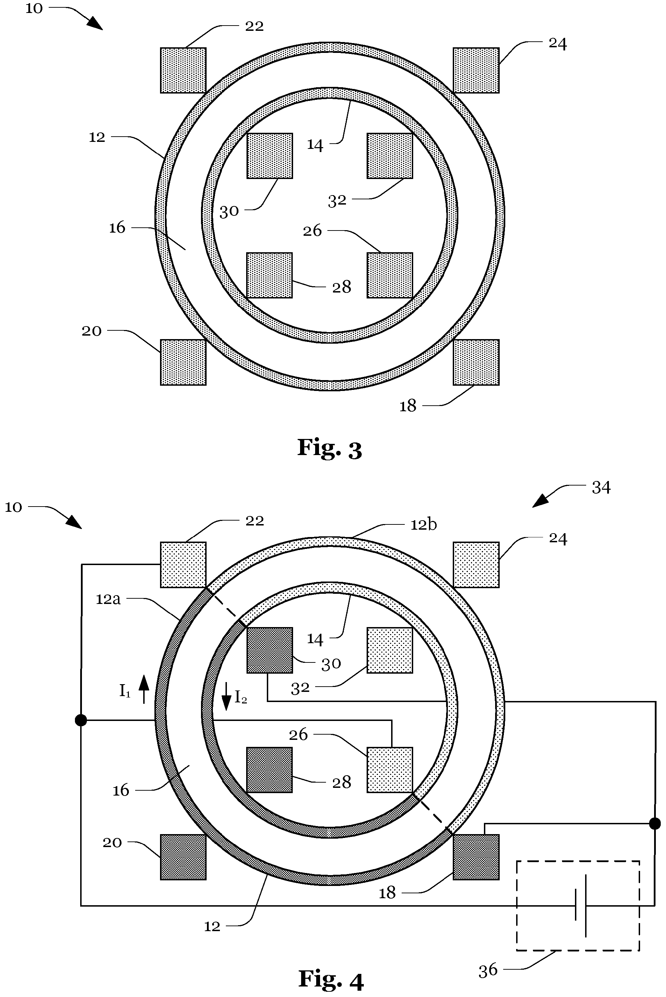

As schematically illustrated in Fig. 3 the structure 10 may form a Corbino ring (instead of a rectangle as shown in Fig. 1 and Fig. 2) with the four electric contact pairs (i.e., electric contacts 18 and 26, 20 and 28, 22 and 30, and 24 and 32) being evenly distributed around the Corbino ring (at 0°, 90°, 180°, and 270°). As schematically illustrated in Fig. 4, injecting the electrical currents I₁ and I₂ may divide the ring into two halves (at 0° and 180°), delineated by electric contacts 18 and 26 on one end and electric contacts 22 and 30 on the other end (as indicated by the broken lines).

In this case, the segments 12a and 14a which exhibit the higher electric potential fully overlap in the radial direction and cause the electric field across the bulk 16 to be substantially zero. The same holds true for the segments 12b and 14b which exhibit the lower electric potential (e.g., ground). Thus, a plot representing the potential along the inner edge 14 and projected radially onto the outer edge 12 would match a plot representing the potential along the outer edge 12. Hence, using the structure 10 instead of a classical Hall bar allows for measurements at a much higher current as it avoids a (non-zero) electric field across the bulk 16 which would otherwise drive (or at least contribute to) the quantization breakdown.

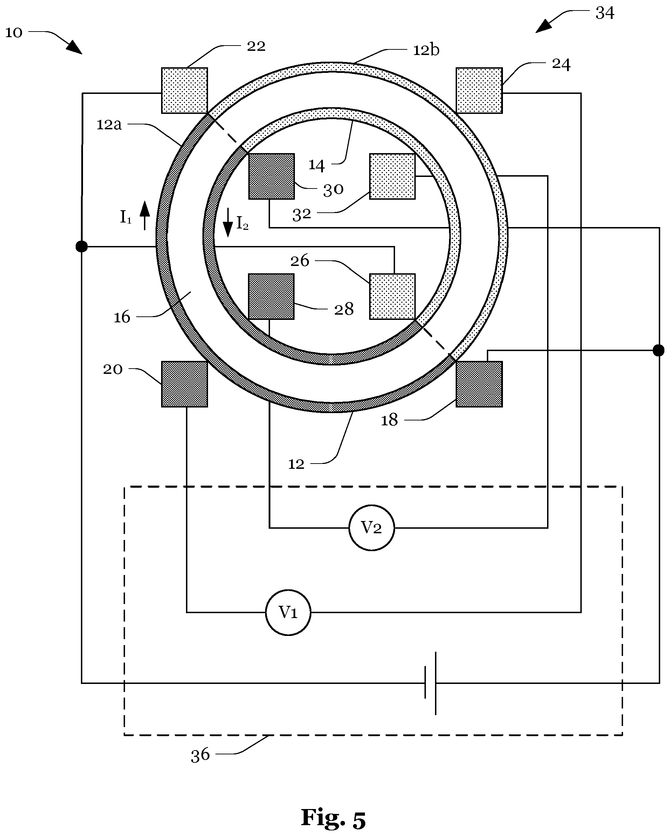

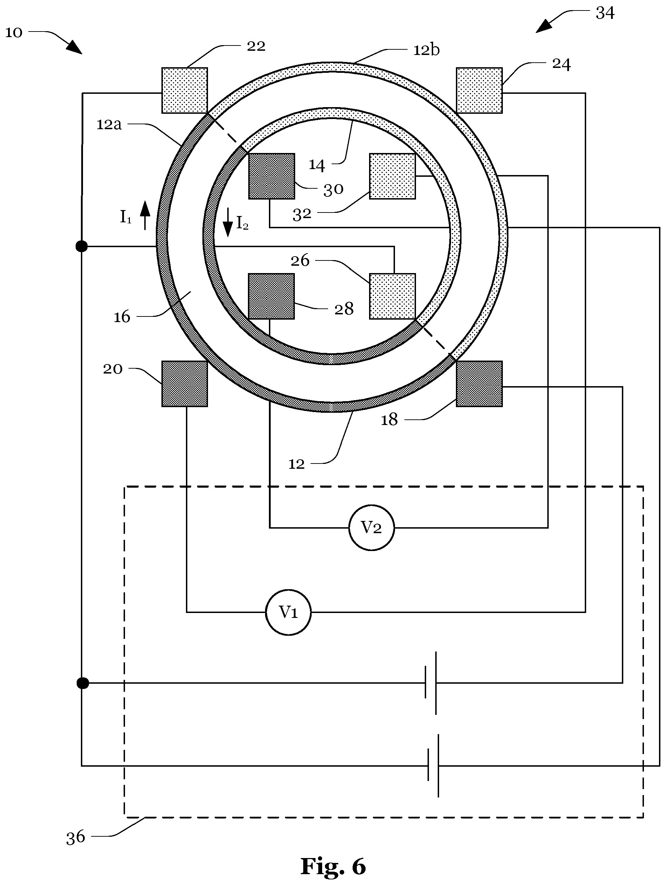

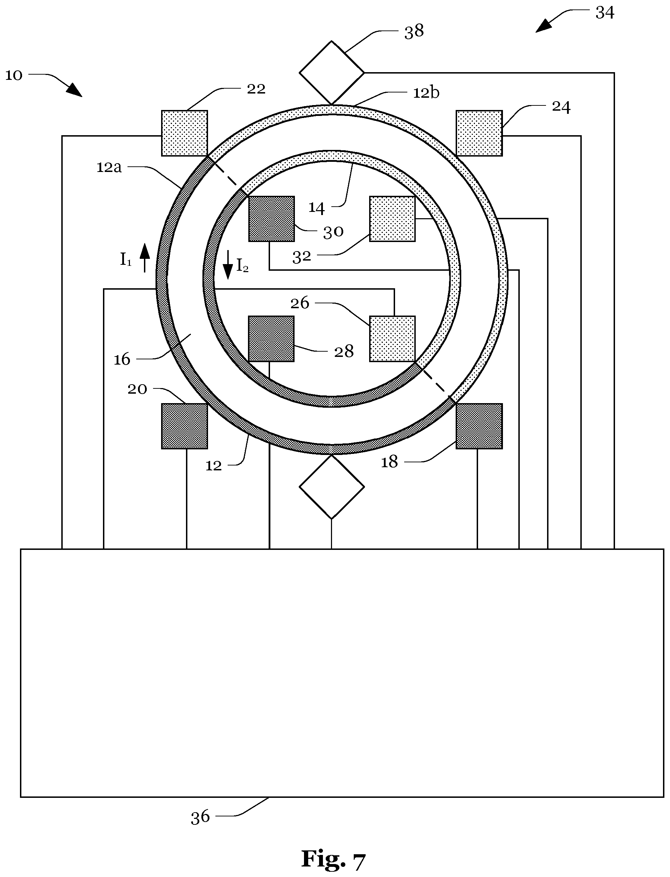

As schematically illustrated in Fig. 5 and Fig. 5b, the controller 36 may measure the voltage between the segments 12a and 12b of the outer edge 12 (or alternatively, or in addition, the voltage between the segments 14a and 14b of the inner edge 14) to determine the von Klitzing constant based on the Quantum Anomalous Hall effect which is exhibited by magnetic topological isolators in the absence of a magnetic field (i.e., zero magnetic field). To this end, the controller 36 may be configured to measure the voltage(s) as a function of the injected electrical current(s). Of course, the structure 10 may also be used in conducting measurements which exploit the Quantum Hall effect. As schematically illustrated in Fig. 6, the first electrical current I₁ and the second electrical I₂ may be generated by two separate sources. Moreover, as schematically illustrated in Fig. 7, the structure 10 may be provided with a gate contact 38 for tuning.

Moreover, the apparatus 34 may comprise a Josephson junction (not shown) to measure the Josephson constant (e.g., by exploiting the AC Josephson effect). When measuring the Josephson constant, a magnetic field generator may be switched off and/or the structure 10 and the Josephson junction or Josephson junction array may be shielded from external magnetic fields. Moreover, the structure 10 and the Josephson junction or Josephson junction array may be integrated into a Kibble balance.

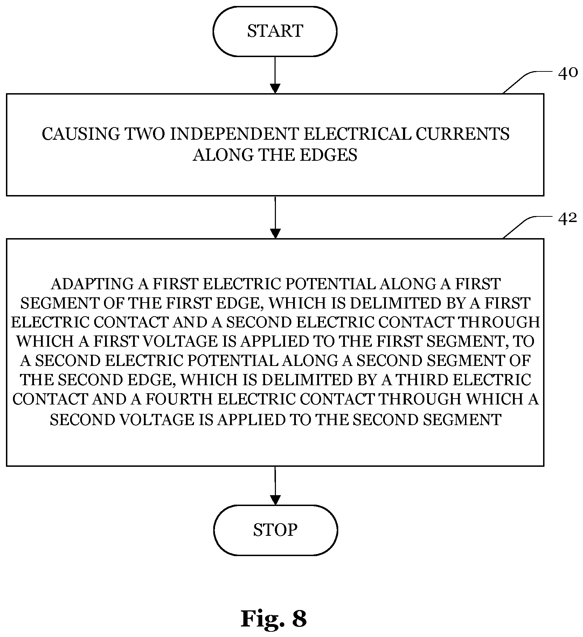

As shown in Fig. 8, a process for protecting the structure 10 against quantization breakdown may start with a step 40 of causing independent electrical currents I₁ and I₂ along the chiral edges 12 and 14. The process may then be continued at step 42 by adapting a first electric potential along a segment 12a of the edge 12, which is delimited by the electric contacts 18 and 22 through which a voltage is applied to the segment 12a, to a second electric potential along a segment 14a of the edge 14, which is delimited by electric contacts 26 and 30 through which the same voltage is applied to the segment 14a.

### Reference Signs List

- 10: structure
- 12: edge
- 12a: segment
- 12b: segment
- 14: edge
- 14a: segment
- 14b: segment
- 16: bulk
- 18: electric contact
- 20: electric contact
- 22: electric contact
- 24: electric contact
- 26: electric contact
- 28: electric contact
- 30: electric contact
- 32: electric contact
- 34: apparatus
- 36: controller
- 38: gate contact
- 40: step
- 42: step

## Claims

1. A method of protecting a structure (10) made of a semiconducting material against quantization breakdown which causes a bulk (16) between a first edge (12) of the structure (10) and a second edge (14) of the structure (10) to conduct electrical charges between the edges, the method comprising:
causing two independent electrical currents along the edges; and
adapting a first electric potential along a first segment (12a) of the first edge (12), which is delimited by a first electric contact (18) and a second electric contact (22) through which a first voltage is applied to the first segment (12a), to a second electric potential along a second segment (14a) of the second edge (14), which is delimited by a third electric contact (26) and a fourth electric contact (30) through which a second voltage is applied to the second segment (14a);
wherein the structure (10) forms a ring having an outer edge and an inner edge, the outer edge of the ring constituting the first edge (12) and the inner edge of the ring constituting the second edge (14);
wherein the semiconductor material is a magnetic topological insulator;
wherein the electric field caused by the second electric potential compensates the electric field caused by the first electric potential such that a resulting electric field is reduced.

2. The method of claim 1, wherein the resulting electric field is zero across the bulk.

3. The method of claim 1 or 2, wherein the ring comprises a first half and a second half and wherein the first segment (12a) constitutes the outer edge of the first half and the second segment (14a) constitutes the inner edge of the first half.

4. The method of claim 3, wherein the first electric contact (18) and the third electric contact (26) are arranged at a first end of the first half, and the second electric contact (22) and the fourth electric contact (30) are arranged at a second end of the first half, and the second voltage between the third electric contact (26) and the fourth electric contact (30) is inverse to the first voltage between the first electric contact (18) and the second electric contact (22).

5. The method of claim 4, wherein an electric potential of the first electric contact (18) is equal to an electric potential of the fourth electric contact (30), and an electric potential of the second electric contact (22) is equal to an electric potential of the third electric contact (26).

6. A method of determining the von Klitzing constant using a structure (10) made of the semiconducting material while protecting the structure (10) against quantization breakdown which causes the bulk (16) between the first edge (12) of the structure (10) and the second edge (14) of the structure (10) to conduct electrical charges between the edges (12, 14), in accordance with the steps of the method of any one of claims 1 to 5, the method comprising:
measuring a third electric potential of the first edge (12), between the first electric contact (18) and the second electric contact (22), or of the second edge (14), between the third electric contact (26) and the fourth electric contact (30);
measuring a fourth electric potential of the first edge (12), outside of the first segment between the second electric contact (22) and the first electric contact (18), or of the second edge (14), outside of the second segment between the fourth electric contact (30) and the third electric contact (26); and
determining, based on the measured third electric potential and the measured fourth electric potential, the von Klitzing constant.

7. The method of claim 6, wherein the structure (10) is exposed to an external magnetic field before or during, measuring the third electric potential.

8. The method of claim 6 or 7, wherein the structure (10) is arranged in a measuring apparatus (34) which further comprises a Josephson junction or a Josephson junction array.

9. The method of claim 8, wherein the structure (10) and the Josephson junction or the Josephson junction array are shielded from external magnetic fields while measuring the third and fourth electric potentials and collecting measurement data for determining the Josephson constant.

10. A measuring apparatus (34), comprising:
a structure (10) having a first edge (12) and a second edge (14);
a device or devices configured to cool the structure (10) and/or to apply a magnetic field to the structure, thereby causing the first edge (12) and the second edge (14) to develop chiral edge states; and
a controller (36) configured to inject a first electrical current into the first edge (12) and a second electrical current into the second edge (14);
wherein the controller (36) is further configured to cause the first electrical current and the second electrical current to flow in opposite directions.

11. The measuring apparatus (34) of claim 10, wherein the first electrical current flows along a first path across a first segment (12a) of the first edge (12) and the second electrical current flows along a second path across a second segment (14a) of the second edge (14), and wherein the controller (36) is further configured to cause a voltage between the first segment (12a) and the second segment (14a) across a bulk (16) of the structure (10) to be zero.

12. The measuring apparatus (34) of claim 10 or 11, wherein the structure (10) forms a Corbino ring having an outer edge and an inner edge, the outer edge of the Corbino ring constituting the first edge (12) and the inner edge of the Corbino ring constituting the second edge (14).

13. The measuring apparatus (34) of claim 12, wherein the Corbino ring comprises a first half and a second half and wherein the first segment (12a) constitutes the outer edge of the first half and the second segment (14a) constitutes the inner edge of the first half.

14. The measuring apparatus (34) of claim 13, further comprising a first electric contact (18) and a third electric contact (26) arranged at a first end of the first half, and a second electric contact (22) and a fourth electric contact (30) arranged at a second end of the first half, wherein a first voltage between the first electric contact (18) and the second electric contact (22) drives the first electrical current and a second voltage between the third electric contact (26) and the fourth electric contact (30) drives the second electrical current.

15. The measuring apparatus (34) of claim 14, wherein an electric potential of the first electric contact (18) is equal to an electric potential of the fourth electric contact (30), and an electric potential of the second electric contact (22) is equal to an electric potential of the third electric contact (26).

## Patentansprüche

1. Verfahren zum Schutz einer Struktur (10) aus einem Halbleitermaterial vor Quantisierungsdurchbruch, der dazu führt, dass ein Volumen (16) zwischen einer ersten Kante (12) und einer zweiten Kante (14) der Struktur (10) elektrische Ladungen zwischen den Kanten leitet, umfassend:
Erzeugen zweier unabhängiger elektrischer Ströme entlang der Kanten; und
Anpassen eines ersten elektrischen Potenzials entlang eines ersten Abschnitts (12a) der ersten Kante (12), der durch einen ersten elektrischen Kontakt (18) und einen zweiten elektrischen Kontakt (22) begrenzt ist, durch die eine erste Spannung an den ersten Abschnitt (12a) angelegt wird, an ein zweites elektrisches Potenzial entlang eines zweiten Abschnitts (14a) der zweiten Kante (14), der durch einen dritten elektrischen Kontakt (26) und einen vierten elektrischen Kontakt (30) begrenzt ist, durch die eine zweite Spannung an den zweiten Abschnitt (14a) angelegt wird;
wobei die Struktur (10) einen Ring mit einer Außen- und einer Innenkante bildet, wobei die Außenkante die erste Kante (12) und die Innenkante die zweite Kante (14) darstellt;
wobei das Halbleitermaterial ein magnetischer topologischer Isolator ist;
wobei das durch das zweite elektrische Potenzial verursachte elektrische Feld das durch das erste elektrische Potenzial verursachte elektrische Feld kompensiert, sodass das resultierende elektrische Feld reduziert wird.

2. Verfahren nach Anspruch 1, wobei das resultierende elektrische Feld über das Volumen Null ist.

3. Verfahren nach Anspruch 1 oder 2, wobei der Ring aus einer ersten und einer zweiten Hälfte besteht und das erste Segment (12a) die Außenkante der ersten Hälfte und das zweite Segment (14a) die Innenkante der ersten Hälfte darstellt.

4. Verfahren nach Anspruch 3, wobei der erste elektrische Kontakt (18) und der dritte elektrische Kontakt (26) an einem ersten Ende der ersten Hälfte und der zweite elektrische Kontakt (22) und der vierte elektrische Kontakt (30) an einem zweiten Ende der ersten Hälfte angeordnet sind und die zweite Spannung zwischen dem dritten elektrischen Kontakt (26) und dem vierten elektrischen Kontakt (30) zur ersten Spannung zwischen dem ersten elektrischen Kontakt (18) und dem zweiten elektrischen Kontakt (22) invertiert ist.

5. Verfahren nach Anspruch 4, wobei das elektrische Potenzial des ersten elektrischen Kontakts (18) dem elektrischen Potenzial des vierten elektrischen Kontakts (30) und das elektrische Potenzial des zweiten elektrischen Kontakts (22) dem elektrischen Potenzial des dritten elektrischen Kontakts (26) entspricht.

6. Verfahren zur Bestimmung der Von-Klitzing-Konstante unter Verwendung einer Struktur (10) aus dem Halbleitermaterial, wobei die Struktur (10) vor einem Quantisierungsdurchbruch geschützt wird, der dazu führt, dass da Volumen (16) zwischen der ersten Kante (12) und der zweiten Kante (14) der Struktur (10) elektrische Ladungen zwischen den Kanten (12, 14) leitet, gemäß den Verfahrensschritten eines der Ansprüche 1 bis 5, wobei das Verfahren umfasst:
Messen eines dritten elektrischen Potenzials der ersten Kante (12) zwischen dem ersten elektrischen Kontakt (18) und dem zweiten elektrischen Kontakt (22) oder der zweiten Kante (14) zwischen dem dritten elektrischen Kontakt (26) und dem vierten elektrischen Kontakt (30);
Messen eines vierten elektrischen Potenzials der ersten Kante (12) außerhalb des ersten Abschnitts zwischen dem zweiten elektrischen Kontakt (22) und dem ersten elektrischen Kontakt (18) oder der zweiten Kante (14) außerhalb des zweiten Abschnitts zwischen dem vierten elektrischen Kontakt (30) und dem dritten elektrischen Kontakt (26); und
Bestimmen der Von-Klitzing-Konstante basierend auf dem gemessenen dritten und vierten elektrischen Potenzial.

7. Verfahren nach Anspruch 6, wobei die Struktur (10) vor oder während der Messung des dritten elektrischen Potenzials einem externen Magnetfeld ausgesetzt wird.

8. Verfahren nach Anspruch 6 oder 7, wobei die Struktur (10) in einer Messvorrichtung (34) angeordnet ist, die zusätzlich einen Josephson-Kontakt oder ein Josephson-Kontakt-Array umfasst.

9. Verfahren nach Anspruch 8, wobei die Struktur (10) und der Josephson-Kontakt oder das Josephson-Kontakt-Array während der Messung des dritten und vierten elektrischen Potenzials und der Erfassung von Messdaten zur Bestimmung der Josephson-Konstante vor externen Magnetfeldern abgeschirmt sind.

10. Messvorrichtung (34), umfassend:
eine Struktur (10) mit einer ersten Kante (12) und einer zweiten Kante (14);
eine oder mehrere Vorrichtungen zum Kühlen der Struktur (10) und/oder zum Anlegen eines Magnetfelds an die Struktur, wodurch die erste Kante (12) und die zweite Kante (14) chirale Randzustände entwickeln; und
eine Steuerung (36), die einen ersten elektrischen Strom in die erste Kante (12) und einen zweiten elektrischen Strom in die zweite Kante (14) einspeist;
wobei die Steuerung (36) ferner so konfiguriert ist, dass der erste und der zweite elektrische Strom in entgegengesetzte Richtungen fließen.

11. Messvorrichtung (34) nach Anspruch 10, wobei der erste elektrische Strom entlang eines ersten Pfades über ein erstes Segment (12a) der ersten Kante (12) und der zweite elektrische Strom entlang eines zweiten Pfades über ein zweites Segment (14a) der zweiten Kante (14) fließt und wobei die Steuerung (36) ferner eingerichtet ist zu bewirken, dass eine Spannung zwischen dem ersten Segment (12a) und dem zweiten Segment (14a) über einem Volumen (16) der Struktur (10) Null ist.

12. Messvorrichtung (34) nach Anspruch 10 oder 11, wobei die Struktur (10) einen Corbino-Ring mit einer Außen- und einer Innenkante bildet, wobei die Außenkante des Corbino-Rings die erste Kante (12) und die Innenkante die zweite Kante (14) bildet.

13. Messvorrichtung (34) nach Anspruch 12, wobei der Corbino-Ring aus einer ersten und einer zweiten Hälfte besteht, wobei das erste Segment (12a) den äußeren Rand der ersten Hälfte und das zweite Segment (14a) den inneren Rand der ersten Hälfte bildet.

14. Messvorrichtung (34) nach Anspruch 13, ferner umfassend einen ersten elektrischen Kontakt (18) und einen dritten elektrischen Kontakt (26), die an einem ersten Ende der ersten Hälfte angeordnet sind, sowie einen zweiten elektrischen Kontakt (22) und einen vierten elektrischen Kontakt (30), die an einem zweiten Ende der ersten Hälfte angeordnet sind, wobei eine erste Spannung zwischen dem ersten elektrischen Kontakt (18) und dem zweiten elektrischen Kontakt (22) den ersten elektrischen Strom und eine zweite Spannung zwischen dem dritten elektrischen Kontakt (26) und dem vierten elektrischen Kontakt (30) den zweiten elektrischen Strom antreibt.

15. Messvorrichtung (34) nach Anspruch 14, wobei ein elektrisches Potenzial des ersten elektrischen Kontakts (18) gleich einem elektrischen Potenzial des vierten elektrischen Kontakts (30) ist und ein elektrisches Potenzial des zweiten elektrischen Kontakts (22) gleich einem elektrischen Potenzial des dritten elektrischen Kontakts (26) ist.

## Revendications

1. Procédé de protection d'une structure (10) composée d'un matériau semi-conducteur contre une rupture de quantification qui amène une masse (16) entre un premier bord (12) de la structure (10) et un second bord (14) de la structure (10) à conduire des charges électriques entre les bords, le procédé comprenant :
la provocation de deux courants électriques indépendants le long des bords ; et
l'adaptation d'un premier potentiel électrique le long d'un premier segment (12a) du premier bord (12), qui est délimité par un premier contact électrique (18) et un deuxième contact électrique (22) au moyen desquels une première tension est appliquée au premier segment (12a), à un deuxième potentiel électrique le long d'un second segment (14a) du second bord (14), qui est délimité par un troisième contact électrique (26) et un quatrième contact électrique (30) au moyen desquels une seconde tension est appliquée au second segment (14a) ;
dans lequel la structure (10) forme un anneau présentant un bord externe et un bord interne, le bord externe de l'anneau constituant le premier bord (12) et le bord interne de l'anneau constituant le second bord (14) ;
dans lequel le matériau semi-conducteur est un isolant topologique magnétique ;
dans lequel le champ électrique provoqué par le deuxième potentiel électrique compense le champ électrique provoqué par le premier potentiel électrique de telle sorte qu'un champ électrique résultant soit réduit.

2. Procédé selon la revendication 1, dans lequel le champ électrique résultant est nul à travers la masse.

3. Procédé selon la revendication 1 ou 2, dans lequel l'anneau comprend une première moitié et une seconde moitié et dans lequel le premier segment (12a) constitue le bord externe de la première moitié et le second segment (14a) constitue le bord interne de la première moitié.

4. Procédé selon la revendication 3, dans lequel le premier contact électrique (18) et le troisième contact électrique (26) sont agencés à une première extrémité de la première moitié, et le deuxième contact électrique (22) et le quatrième contact électrique (30) sont agencés à une seconde extrémité de la première moitié, et la seconde tension entre le troisième contact électrique (26) et le quatrième contact électrique (30) est inverse de la première tension entre le premier contact électrique (18) et le deuxième contact électrique (22).

5. Procédé selon la revendication 4, dans lequel un potentiel électrique du premier contact électrique (18) est égal à un potentiel électrique du quatrième contact électrique (30), et un potentiel électrique du deuxième contact électrique (22) est égal à un potentiel électrique du troisième contact électrique (26).

6. Procédé de détermination de la constante de von Klitzing utilisant une structure (10) composée du matériau semi-conducteur tout en protégeant la structure (10) contre une rupture de quantification qui amène la masse (16) entre le premier bord (12) de la structure (10) et le second bord (14) de la structure (10) à conduire des charges électriques entre les bords (12, 14), selon les étapes du procédé selon l'une quelconque des revendications 1 à 5, le procédé comprenant :
la mesure d'un troisième potentiel électrique du premier bord (12), entre le premier contact électrique (18) et le deuxième contact électrique (22), ou du second bord (14), entre le troisième contact électrique (26) et le quatrième contact électrique (30) ;
la mesure d'un quatrième potentiel électrique du premier bord (12), à l'extérieur du premier segment entre le deuxième contact électrique (22) et le premier contact électrique (18), ou du second bord (14), à l'extérieur du second segment entre le quatrième contact électrique (30) et le troisième contact électrique (26) ; et
la détermination, sur la base du troisième potentiel électrique mesuré et du quatrième potentiel électrique mesuré, de la constante de von Klitzing.

7. Procédé selon la revendication 6, dans lequel la structure (10) est exposée à un champ magnétique externe avant ou pendant la mesure du troisième potentiel électrique.

8. Procédé selon la revendication 6 ou 7, dans lequel la structure (10) est agencée dans un appareil de mesure (34) qui comprend en outre une jonction Josephson ou un réseau de jonctions Josephson.

9. Procédé selon la revendication 8, dans lequel la structure (10) et la jonction Josephson ou le réseau de jonctions Josephson sont protégés des champs magnétiques externes tout en mesurant les troisième et quatrième potentiels électriques et en collectant des données de mesure pour déterminer la constante de Josephson.

10. Appareil de mesure (34), comprenant :
une structure (10) présentant un premier bord (12) et un second bord (14) ;
un dispositif ou des dispositifs configurés pour refroidir la structure (10) et/ou pour appliquer un champ magnétique à la structure, amenant ainsi le premier bord (12) et le second bord (14) à développer des états de bord chiraux ; et
un dispositif de commande (36) configuré pour injecter un premier courant électrique dans le premier bord (12) et un second courant électrique dans le second bord (14) ;
dans lequel le dispositif de commande (36) est en outre configuré pour amener le premier courant électrique et le second courant électrique à circuler dans des directions opposées.

11. Appareil de mesure (34) selon la revendication 10, dans lequel le premier courant électrique circule le long d'un premier trajet à travers un premier segment (12a) du premier bord (12) et le second courant électrique circule le long d'un second trajet à travers un second segment (14a) du second bord (14) et dans lequel le dispositif de commande (36) est en outre configuré pour amener une tension entre le premier segment (12a) et le second segment (14a) à travers une masse (16) de la structure (10) à être nulle.

12. Appareil de mesure (34) selon la revendication 10 ou 11, dans lequel la structure (10) forme un anneau de Corbino présentant un bord externe et un bord interne, le bord externe de l'anneau de Corbino constituant le premier bord (12) et le bord interne de l'anneau de Corbino constituant le second bord (14).

13. Appareil de mesure (34) selon la revendication 12, dans lequel l'anneau de Corbino comprend une première moitié et une seconde moitié et dans lequel le premier segment (12a) constitue le bord externe de la première moitié et le second segment (14a) constitue le bord interne de la première moitié.

14. Appareil de mesure (34) selon la revendication 13, comprenant en outre un premier contact électrique (18) et un troisième contact électrique (26) agencés à une première extrémité de la première moitié, et un deuxième contact électrique (22) et un quatrième contact électrique (30) agencés à une seconde extrémité de la première moitié, dans lequel une première tension entre le premier contact électrique (18) et le deuxième contact électrique (22) entraîne le premier courant électrique et une seconde tension entre le troisième contact électrique (26) et le quatrième contact électrique (30) entraîne le second courant électrique.

15. Appareil de mesure (34) selon la revendication 14, dans lequel un potentiel électrique du premier contact électrique (18) est égal à un potentiel électrique du quatrième contact électrique (30), et un potentiel électrique du deuxième contact électrique (22) est égal à un potentiel électrique du troisième contact électrique (26).
